# EUROPÄISCHE PATENTANMELDUNG

(11) **EP 3 787 014 A1**
(43) Veröffentlichungstag der Anmeldung: **03.03.2021**
(21) Anmeldenummer: 19194361.2
(22) Anmeldetag: 29.08.2019
(51) Int. Cl.: H01L 21/67, B23K 3/047, G01K 7/42, G01K 3/04, B23K 1/008, B23K 3/08, F27B 9/40, F27D 19/00

(54) **ERFASSUNG VON PROZESSPARAMETERN EINER MONTAGELINIE**

(71) Anmelder: Siemens Aktiengesellschaft, 80333 München (DE)
(72) Erfinder: Hanisch, Michael, 16540 Hohen Neuendorf (DE); Jarchoff, Kay, 13347 Berlin (DE); Massierer, Jonas, 16269 Schulzendorf (DE); Matiwe, Marco, 12555 Berlin (DE); Schubert, Jörg, 12105 Berlin (DE); Sommerfeld, Dennis, 12347 Berlin (DE); Wittreich, Ulrich, 16727 Velten (DE); Wormuth, Dirk, 12203 Berlin (DE)

(57) **Zusammenfassung**

Die Erfindung betrifft eine Vorrichtung (100), die zur Erfassung von Prozessparametern während eines Durchlaufs einer Montagelinie (500) zur Montage von elektronischen Bauteilen und/oder zum Auftrag von Fügematerialien ausgebildet ist. Um die Erfassung von Prozessparametern über eine gesamte Montagelinie hinweg zu ermöglichen wird weist die Vorrichtung einen Träger (120) auf, der zur Beförderung mit einem Fördersystem (560) der Montagelinie (500) und zur Aufnahme einer Testplatte (110) ausgebildet ist, und zumindest einen Sensor (F, E, A, T) zur Messung zumindest eines Prozessparameters während des Durchlaufs. Die Erfindung betrifft weiterhin ein System aus einer Vorrichtung (100) und einer Testplatte (110) .

## Beschreibung

Die Erfindung betrifft eine Vorrichtung zur Erfassung von Prozessparametern während eines Durchlaufs einer Montagelinie. Die Erfindung betrifft weiterhin ein System aus einer Vorrichtung und einer Testplatte. Die Montagelinie ist dabei zur Montage von elektronischen Bauteilen und/oder zum Aufbringen von Fügematerialien ausgebildet und kommt bei der Fertigung von elektronischen Produkten, insbesondere unter Einsatz von SMD-Bauteilen zum Einsatz. Als Fügematerialien sind dabei beispielsweise Lot-/ Sinterpasten oder Kleber im Einsatz. Bisher werden lediglich einzelne Geräte getestet. Das Testen einzelner Geräte hat dabei nur wenig Aussagekraft bezüglich des Zusammenspiels der gesamten Montagelinie.

Es ist Aufgabe der Erfindung, die Erfassung von Prozessparametern über eine gesamte Montagelinie hinweg zu ermöglichen.

Zur Lösung der Aufgabe wird eine Vorrichtung zur Erfassung von Prozessparametern während eines Durchlaufs einer Montagelinie vorgeschlagen. Die Vorrichtung weist dazu einen Träger auf, der zur Beförderung mit einem Fördersystem der Montagelinie und zur Aufnahme einer Testplatte ausgebildet ist. Die Vorrichtung weist weiterhin zumindest einen Sensor zur Messung zumindest eines Prozessparameters während des Durchlaufs auf. Das Fördersystem erstreckt sich durch die ganze Montagelinie und so kann die Vorrichtung wie ein reales Produkt die Montagelinie durchlaufen und dabei kontinuierlich entsprechende prozessrelevante Kenndaten erfassen und aufzeichnen. Der große Vorteil liegt darin, dass unter Fertigungs-Bedingungen Parameter erfasst werden können. In einem weiteren Schritt können Parameter der Montagelinie angepasst werden, um einen erheblichen Einfluss auf die Qualität der Montagelinie bzw. der Endprodukte zu erwirken.

Vorzugsweise kommt eine solche Vorrichtung bei einer SMD-Montagelinie zum Einsatz und kann dabei beispielsweise zur Ermittlung von Beschleunigungen und/oder Vibrationen der Transportmodule verwendet werden. Weiterhin kann beim Schablonendruck eine Kraftverteilung während des Rakelvorgangs, das Klima, die Temperatur des gedruckten Mediums und die Positioniergenauigkeit der Schablone erfasst werden. Bei Bestückautomaten können ebenso die Beschleunigungen und Vibrationen erfasst werden sowie die Bestückkräfte, die auf die Testplatte bzw. weitere Bauelemente wirken. Hier kann für verschiedene Pipetten bzw. Bestückköpfe jeweils ein Programm durchgetestet werden. Auch die Positioniergenauigkeit bzw. die tatsächliche Positionierung der Bauteile, die auf der Testplatte positioniert werden, kann beurteilt werden. Für Dispensautomaten oder sogenannte Dispenser können Beschleunigung und/oder Vibrationen erfasst werden, die Temperatur des dispensten Mediums, das Klima im Dispenser und die Positioniergenauigkeit des Dispensers.

In einer weiteren Ausführungsform weist die Vorrichtung ein oder mehrere Kraftsensoren auf, die so angeordnet sind, dass eine Kraft und/oder Kraftverteilung erfassbar ist, die während des Durchlaufs auf die Testplatte wirkt. Insbesondere die Kraftverteilung eines Rakels beim Schablonendruck von beispielsweise Lotpaste ist hier von Interesse. Es kann weiterhin von Interesse sein, Kraftspitzen an einzelnen Stellen zu erkennen und ggf. Beschädigungen an der zu bestückenden Leiterplatte bzw. an Bauteilen zu verhindern.

In einer weiteren Ausführungsform weist die Vorrichtung einen Klimasensor auf. Dieser ist vorzugsweise zur Erfassung von Temperatur- und Luftfeuchtigkeit ausgebildet. Der Klimasensor kann weiterhin zur Erfassung von Stäuben bzw. Feinstäuben ausgebildet sein, um zu ermitteln, ob eine unzulässige Belastung mit solchen Stäuben vorliegt und um ggf. die Quellen der Verunreinigungen ermitteln zu können.

In einer weiteren Ausführungsform weist die Vorrichtung einen Beschleunigungssensor zur Erfassung der Beschleunigung der Vorrichtung auf. Die Beschleunigungen, die während eines Durchlaufs der Montagelinie auf die Vorrichtung einwirken, entsprechenden den Beschleunigungen, die auch auf eine reale Leiterplatte einwirken, während sie den Prozess durchläuft. Hier können beispielsweise Abschnitte mit zu hoher Beschleunigung identifiziert werden, um ggf. ein Verrutschen von Bauelementen zu verhindern oder Abschnitte mit zu langsamer Beschleunigung verbessert werden, um eine Optimierung der Durchlaufzeit zu erreichen.

In einer weiteren Ausführungsform weist die Vorrichtung einen optischen Sensor auf. Der optische Sensor ist dabei so angeordnet, dass er einen Fügematerialauftrag von unterhalb einer Abdeckung und/oder der Testplatte erfassen kann. Dazu kann es zweckmäßig sein, dass zumindest ein Teil der Abdeckung bzw. der Testplatte transparent ausgestaltet ist, sodass der Fügematerialauftrag von unten begutachtet werden kann. Dies hat den großen Vorteil, dass der Fügematerialauftrag auf eine Oberfläche, die sonst von der Lotpaste selbst verdeckt ist, begutachtet werden kann. Der optische Sensor kann dabei als eine Kamera ausgebildet sein, die z. B. einen Offset des dispensten Materials bzw. einer Nadelspitze eines Dispenssystems ermitteln kann.

In einer weiteren Ausführungsform weist die Vorrichtung Fiducial und/oder Passermarken auf. Solche Marken dienen der Erkennung der Ausrichtung der Vorrichtung und sind üblicherweise auf Leiterplatten aufgebracht, damit diese in der korrekten Ausrichtung den Prozess durchlaufen können. Insbesondere zur genauen Positionierung von Bauteilen, die in Relation zu mehreren Marken positioniert werden, kommen solche Marken zum Einsatz. So kann auch auf der Vorrichtung eine hohe Positioniergenauigkeit erreicht und getestet werden.

In einer weiteren Ausführungsform weist die Vorrichtung zumindest eine Identifikationsmarkierung auf. Eine Solche Identifikationsvorrichtung kann beispielsweise als maschinenlesbarer Code, z. B. ein Barcode oder ein QR-Code, ausgestaltet sein. Die Vorrichtung kann so immer eindeutig identifiziert werden und es kann so eine eindeutige Identifikation in den erfassten Prozessparametern hinterlegt werden, um eine spätere Auswertung zu erleichtern.

Eine weitere Ausführungsform der Vorrichtung weist einen Temperatursensor, insbesondere ein Oberflächenthermoelement auf. Das Oberflächenthermoelement kann dabei dazu verwendet werden, Pasten oder andere Materialien direkt auf die Oberfläche des Thermoelements zu positionieren und die Temperatur des Mediums direkt bei Kontakt mit der Oberfläche zu erfassen.

In einer weiteren Ausführungsform weist die Vorrichtung eine Kommunikationsschnittstelle auf. Diese kann als drahtgebundene Kommunikationsschnittstelle ausgebildet sein. Wenn die Vorrichtung einen Speicher aufweist, kann über die Kommunikationsverbindung der Speicher ausgelesen werden. Weiterhin kann die Vorrichtung eine drahtlose Schnittstelle aufweisen, die es ermöglicht, die Daten in Echtzeit aus der Vorrichtung heraus zur Auswertung zu schicken.

In einer weiteren Ausführungsform weist die Vorrichtung eine Energieversorgungsvorrichtung auf. Die Energieversorgungsvorrichtung ist dabei vorzugsweise ausgebildet, um zumindest die Energie für die Sensoren für zumindest einen Durchlauf zur Verfügung zu stellen. Dazu gehört ebenso die Aufzeichnung der Sensordaten wie die ggf. vorhandene Kommunikation der Sensordaten nach außen. Hier können beispielsweise Akkus zum Einsatz kommen.

In einer weiteren Ausführungsform weist die Vorrichtung einen Datenspeicher und/oder eine Auswerteeinheit auf. Je nach Einsatzort der Vorrichtung kann es vorteilhaft sein, die Sensordaten dauerhaft in der Vorrichtung zu speichern und die Daten für spätere Auswertungen an einem anderen Ort zur Verfügung zu haben. Es ist ebenso denkbar, dass eine Auswerteeinheit direkt auf einen Datenspeicher zugreift und erste Auswertungen von Qualitätskriterien sofort durchführt z. B. um diese direkt anzuzeigen. Eine Anzeige kann dabei über ein Display direkt auf der Vorrichtung erfolgen, kann aber ebenso über eine drahtlose oder drahtgebundene Kommunikationsschnittstelle an ein Auswertegerät weitergeleitet werden.

Die Aufgabe wird weiterhin durch ein System aus einer Vorrichtung gemäß einer der obenstehenden Ausführungsformen und einer Testplatte gelöst. Die genannten Ausführungsformen können dabei untereinander kombiniert werden und ergänzen sich gegenseitig. So kann ein Beschleunigungssensor in Verbindung mit den Kraftsensoren ein genaues Kraft-Beschleunigungsprofil erzeugen. Vibrationen können hier ebenso erfasst werden. Die Testplatte kann dabei als eine gut reinigbare Glasplatte ausgebildet sein, die auch den Vorteil hat, optisch transparent zu sein. Weiterhin sind weitere Materialien denkbar, die eine gute Oberflächenbeschaffenheit und Reinigbarkeit aufweisen. Testplatten können dabei auch als Einweg-Testplatten ausgebildet sein, die nach der Verwendung als Testplatte archiviert werden oder einem weiteren Verarbeitungsschritt zugeführt werden.

In einer weiteren Ausführungsform ist die Testplatte als eine Leiterplatte ausgebildet. Dies hat den Vorteil, dass handelsübliche Leiterplatten in die Aufnahme der Vorrichtung aufgenommen werden können, um dann unter Bedingungen zu testen, die den realen Bedingungen nahekommen. Hierbei ist es möglich, dass die Leiterplatte bereits Sensorik aufweist, die über die Aufnahme der Vorrichtung kontaktiert werden kann und so auch Messwerte liefern kann.

In einer weiteren Ausführungsform weist die Testplatte eine berührungsempfindliche Oberfläche auf. Dies kann beispielsweise wie ein Touchelement eines Touchscreens ausgebildet sein. Hierzu sind kapazitive, induktive oder resistive Verfahren denkbar. Der Vorteil hiervon ist, dass die Positionierung von einzelnen Elementen erfasst werden kann. Da bswp. Lotpaste elektrisch leitend ist, ist eine Erkennung über ein kapazitives Verfahren problemlos möglich.

In einer weiteren Ausführungsform weist die Testplatte Teststellen auf, die so ausgebildet sind, dass ein qualitativ minderwertiger Lotpastenauftrag entsteht oder simuliert wird. Ein minderwertiger Lotpastenauftrag dient zum Testen von Lotpasteninspektionssystemen (auch SPI genannt) zu testen, um z. B. zu überprüfen, ob eine Fehlermeldung ausgelöst wird, wenn ein minderwertiger Lotpastenauftrag erkannt wird oder ob dieser überhaupt erkannt wird. Um einen qualitativ minderwertigen Lotpastenauftrag zu erzeugen, kann die Oberfläche der Testplatte Unregelmäßigkeiten aufweisen oder der minderwertige Lotpastenauftrag mit Testdummies simuliert werden, die bestückt werden können und Unregelmäßigkeiten aufweisen.

Im Folgenden wird die Erfindung anhand der in den Figuren dargestellten Ausführungsbeispiele näher beschrieben und erläutert. Es zeigen:
- FIG 1: eine Ausführungsform einer Vorrichtung
- FIG 2: eine Montagelinie.

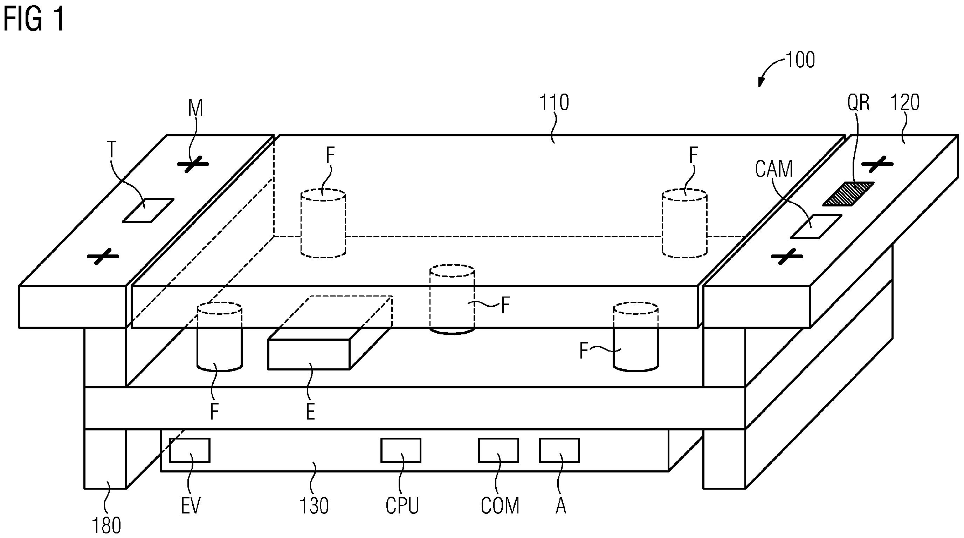

Figur 1 zeigt eine Ausführungsform einer Vorrichtung 100 mit einer Testplatte 110. Die Vorrichtung 100 weist einen wannenförmigen Träger 120 auf. Der Träger 120 steht dabei auf zwei Stützelementen 180, die hier als Füße ausgebildet sind und an der Unterseite der Vorrichtung angeordnete Elektronik schützen. Der Träger 120 ist dabei so ausgebildet, dass er mit oder ohne Stützelementen 180 mit einem Transportsystem einer Montagelinie transportiert werden kann und von den einzelnen zu überprüfenden Prozessschritten auch bearbeitet werden kann. So ist die Testplatte 110 so ausgebildet, dass sie beispielsweise mit einem Rakeldruckverfahren mit Lotpaste versehen werden kann und mit einem Bestückautomaten mit SMD-Bauteilen bestückt werden kann.

Die Testplatte 110 ist in diesem Fall auf fünf Kraftsensoren F angeordnet. Die Kraftsensoren F sind dabei so angeordnet, dass ein möglichst vollständiges Bild einer Kraftverteilung, beispielsweise des Rakels bei einem Lotpastenauftrag bei einem Siebdruckverfahren, ermöglicht wird. Weiterhin weist die Vorrichtung 100 einen Klimasensor E auf, der die Umweltbedingungen, insbesondere bezüglich Temperatur und Luftfeuchtigkeit erfasst. Unterhalb des Trägers 120 ist ein Elektronikmodul 150 angeordnet, das einen Prozessor CPU, eine Energieversorgungseinrichtung EV sowie einen Beschleunigungssensor A aufweist. Das Elektronikmodul 150 kann dabei auch in den Träger 120 integriert werden.

Der Träger 120 weist Marken M auf, die in den Ecken des Trägers 120 angeordnet sind und eine genaue Ausrichtung des Trägers ermöglichen. Weiterhin weist die Vorrichtung 100 eine Identifikationsmarkierung QR auf, die beispielsweise als QR-Code ausgebildet sein kann. Die Identifikationsmarkierung kann dabei z. B. mittels eines e-Paper Displays angezeigt werden und kann von Durchlauf zu Durchlauf verändert werden. Weiterhin weist die Vorrichtung 100 ein Oberflächenthermoelement T auf, also einen Temperatursensor, der die Temperatur an der Oberfläche der Vorrichtung 100 erfasst und damit beispielsweise die Temperatur eines auf den Sensor aufgebrachten Mediums.

Ein optischer Sensor CAM ist unterhalb einer Glasscheibe im Träger 120 angebracht, wobei auf diesen Teil des Trägers Dispenstests durchgeführt werden können. Es ist ebenso denkbar, dass Teile der Testplatte 110 transparent ausgestaltet sind und der optische Sensor CAM oder weitere Sensoren unterhalb der Testplatte angeordnet werden.

Der Träger 120 und die Testplatte 110 können dabei auch einteilig ausgestaltet sein, d.h. Träger 120 und Testplatte 110 können monolithisch aufgebaut sein.

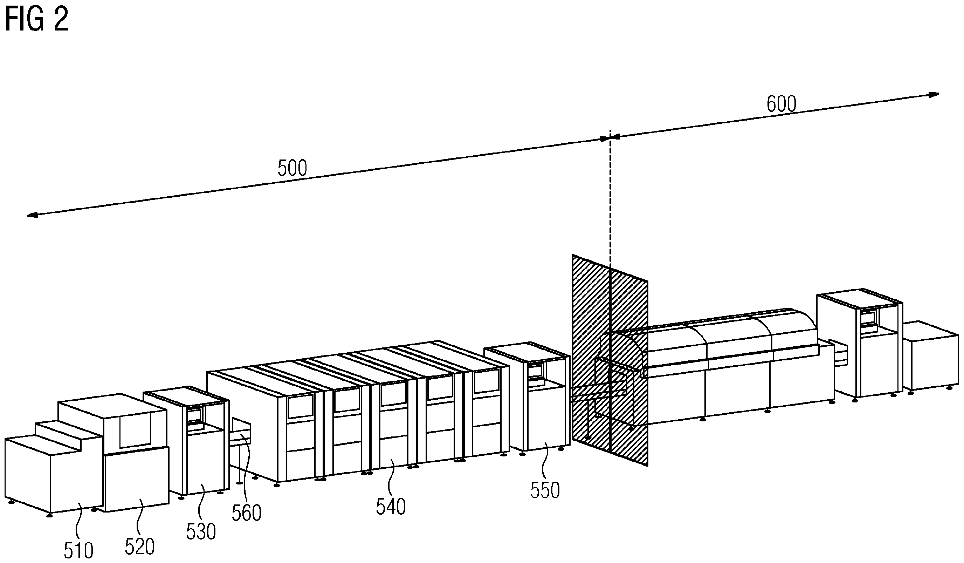

Figur 2 zeigt eine Montagelinie 500, gefolgt von einer Lötanlage 600. Die erfindungsgemäße Vorrichtung 100 soll dabei in der Montagelinie 500 zum Einsatz kommen, deren Parameter erfassen und zur Verbesserung der Parameter beitragen. Ein PCB-Lager 510 dient zur Lagerung für unbestückte PCBs oder anderer Substrate. Ein Schablonendruckautomat 520 dient zum Aufdrucken von Lotpaste auf die PCBs. Eine Lotpasteninspektion 530 (im Englischen: "Solder Paste Inspection" - SPI) prüft ob die Lotpaste erwartungsgemäß aufgetragen wurde. Ein oder mehrere Bestückautomaten 540 platzieren die Bauteile auf dem PCB bzw. den beloteten Plätzen. Als in diesem Fall letzter Schritt vor dem Reflow-Löten ist eine Automatisierte Optische Inspektion 550 vorgesehen (im Englischen: "automated optical inspection" - in diesem Fall eine "Pre Reflow AOI"). Da die Montagelinie 500 Platzoptimal aufgebaut ist, ist ein Transportsystem 560 nur zwischen der Lotpasteninspektion 530 und den Bestückautomaten 540 zu sehen, das Transportsystem 560 erstreckt sich aber durch die gesamte Montagelinie 500 und kann dementsprechend die Vorrichtung 100 durch die Montagelinie 500 transportieren.

Die Erfindung betrifft zusammenfassend eine Vorrichtung (100), die zur Erfassung von Prozessparametern während eines Durchlaufs einer Montagelinie (500) zur Montage von elektronischen Bauteilen und/oder zum Auftrag von Fügematerialien ausgebildet ist. Um die Erfassung von Prozessparametern über eine gesamte Montagelinie hinweg zu ermöglichen wird weist die Vorrichtung einen Träger (120) auf, der zur Beförderung mit einem Fördersystem (560) der Montagelinie (500) und zur Aufnahme einer Testplatte (110) ausgebildet ist, und zumindest einen Sensor (F, E, A, T) zur Messung zumindest eines Prozessparameters während des Durchlaufs. Die Erfindung betrifft weiterhin ein System aus einer Vorrichtung (100) und einer Testplatte (110).

## Patentansprüche

1. Vorrichtung (100) zur Erfassung von Prozessparametern während eines Durchlaufs einer Montagelinie (500) zur Montage von elektronischen Bauteilen und/oder zum Auftrag von Fügematerialien aufweisend:
einen Träger (120), der zur Beförderung mit einem Fördersystem (560) der Montagelinie (500) und zur Aufnahme einer Testplatte (110) ausgebildet ist, und
zumindest einen Sensor (F, E, A, T) zur Messung zumindest eines Prozessparameters während des Durchlaufs.

2. Vorrichtung (100) nach Anspruch 1, aufweisend ein oder mehrere Kraftsensoren (F), die so angeordnet sind, dass eine Kraft und/oder Kraftverteilung erfassbar ist, die während des Durchlaufs auf die Testplatte (110) wirkt.

3. Vorrichtung (100) nach einem der vorhergehenden Ansprüche, aufweisend einen Klimasensor (E).

4. Vorrichtung (100) nach einem der Ansprüche, aufweisend einen Beschleunigungssensor (A), der zur Erfassung der Beschleunigung der Vorrichtung (100) ausgebildet ist, die während eines Durchlaufs der Montagelinie (500) auf die Vorrichtung (100) wirkt.

5. Vorrichtung (100) nach einem der vorhergehenden Ansprüche, aufweisend einen optischen Sensor (CAM), der so angeordnet ist, dass er einen Fügematerialauftrag von unterhalb einer Abdeckung und/oder der Testplatte (110) erfassen kann.

6. Vorrichtung (100) nach einem der vorhergehenden Ansprüche, aufweisend Fiducial- und/oder Passermarken (M).

7. Vorrichtung (100) nach einem der vorhergehenden Ansprüche, aufweisend zumindest eine Identifikationsmarkierung (QR) .

8. Vorrichtung (100) nach einem der vorhergehenden Ansprüche, aufweisend zumindest ein Temperatursensor (T).

9. Vorrichtung (100) nach einem der vorhergehenden Ansprüche, aufweisend eine Kommunikationsschnittstelle (COM).

10. Vorrichtung (100) nach einem der vorhergehenden Ansprüche, aufweisend eine Energieversorgungseinrichtung (EV).

11. Vorrichtung (100) nach einem der vorhergehenden Ansprüche, aufweisend einen Datenspeicher und/oder eine Auswerteeinheit.

12. System aus einer Vorrichtung (100) gemäß einem der vorhergehenden Ansprüche und einer Testplatte (110).

13. System nach Anspruch 12, wobei die Testplatte (110) eine Leiterplatte ist.

14. System nach Anspruch 12 oder 13, wobei die Testplatte (110) eine berührungsempfindliche Oberfläche aufweist.

15. System nach einem der Ansprüche 12 bis 14, wobei die Testplatte (110) Teststellen aufweist, die so ausgebildet sind, dass ein qualitativ minderwertiger Lotpastenauftrag entsteht und/oder simuliert wird.
